# EUROPEAN PATENT APPLICATION

(11) **EP 1 748 490 A1**
(43) Date of publication of application: **31.01.2007**
(21) Application number: 06253793.1
(22) Date of filing: 20.07.2006
(51) Int. Cl.: H01L 27/146, H01L 31/103, H01L 31/0352, H01L 31/18

(54) **Fabrication method for epitaxially grown solid-state image sensing devices and such devices**

(30) Priority: 28.07.2005 JP 2005219217
(71) Applicant: Fuji Photo Film Co., Ltd., Minami-Ashigara-shi, Kanagawa (JP)
(72) Inventor: Okawa, Haru, c/o Fuji Photo Film Co., Ltd., Kurokawa-gun Miyagi (JP); Uya, Shinji, c/o Fuji Photo Film Co., Ltd., Kurokawa-gun Miyagi (JP); Nomura, Yuko, c/o Fuji Photo Film Co., Ltd., Kurokawa-gun Miyagi (JP)
(74) Representative: Stevens, Jason Paul

(57) **Abstract**

A method of producing a solid-state image sensing device comprising a photoelectric conversion region, the method comprising: growing a first epitaxial layer on a semiconductor substrate; forming a part of the photoelectric conversion region in the first epitaxial layer; forming a second epitaxial layer by epitaxial growth on the first epitaxial layer; and forming the remaining part of the photoelectric conversion region in the second epitaxial layer connecting the parts of the photoelectric conversion region in the epitaxial layers.

## Description

### Background of the Invention

### 1. Field of the Invention

The present invention relates to a solid-state image sensing device producing method and a solid-state image sensing device provided with a photodiode which can be formed deeply.

### 2. Description of the Invention

As a solid-state image sensing device, there has been heretofore known a solid-state image sensing device including photo acceptance areas and vertical and horizontal scanning circuits for driving the photo acceptance areas and extracting an image signal as described in JP-A-3-169076.

Fig. 17 is a sectional view schematically showing the configuration of a solid-state image sensing device according to the related art. In the solid-state image sensing device 100 according to the related art, a high density epitaxial layer 102 and a low density epitaxial layer 103 are laminated successively on an N-type semiconductor substrate 101. A P-well layer 104 is formed in the low density epitaxial layer 103. A photodiode 106 and a positive charge storage region 107 on the photodiode 106 are formed in the P-well layer 104. A charge transfer path 109 is formed in a region of the P-well layer 104 adjacent to the positive charge storage region 107. A transfer electrode 105 is formed on a surface of the region where the charge transfer path 109 is formed. As an example, the solid-state image sensing device shown in Fig. 17 further has an overflow drain type configuration in which an overflow drain region 108 is formed in the low density epitaxial layer 103 so as to be arranged side by side with the P-well layer 104. Before transfer of charge, surplus electrons stored in the photodiode 106 are fed out to the outside of the device through the overflow drain region 108.

At present, there is a demand for improvement in sensitivity of the solid-state image sensing device. As measures to attain the improvement in sensitivity of the solid-state image sensing device, there are a method for forming a micro lens on the solid-state image sensing device and a method for forming an intralayer lens to improve light-condensing efficiency. There is however a problem that these methods cannot cope with reduction in size because lowering of light intensity cannot be avoided.

It is therefore conceived that sensitivity of the solid-state image sensing device 100 is improved not by improvement in the light-condensing efficiency but by formation of a photodiode 106 deeply in the direction of the thickness (vertical direction in Fig. 17) of a substrate of the solid-state image sending device 100 to extend a light absorption region up to a deep region. Although the photodiode 106 can be formed up to the deep region when an acceleration voltage for ion injection is increased, the acceleration voltage has its upper limit in terms of device performance. Moreover, it is necessary to increase the film thickness of a photoresist sufficiently in accordance with acceleration of ions to be injected. In addition, a region of ions to be injected is spread in the planar direction of the substrate. Accordingly, it is very difficult to achieve reduction in size.

The invention is achieved under such circumstances. An object of the invention is to provide a solid-state image sensing device producing method and a solid-state image sensing device provided with a photodiode which can be formed deeply.

### Summary of the Invention

The object of the invention is achieved by a method of producing a solid-state image sensing device comprising a photoelectric conversion layer, the method comprising: laminating a first epitaxial layer on a semiconductor substrate; forming a part of the photoelectric conversion layer in the first epitaxial layer; forming a second epitaxial layer by epitaxial growth on the first epitaxial layer; and forming the remaining part of the photoelectric conversion layer in the second epitaxial layer to connect the remaining part of the photoelectric conversion layer to the part of the photoelectric conversion layer in the first epitaxial layer.

A plurality of epitaxial layers such as a third epitaxial layer, a fourth epitaxial layer, etc. may be formed. In this case, the object is achieved by a method of producing a solid-state image sensing device comprising a photoelectric conversion layer, the method comprising: laminating a plurality of epitaxial layers on a semiconductor substrate; and forming the photoelectric conversion layer in the plurality of epitaxial layers so as to be continuous in a direction of lamination of the plurality of epitaxial layers.

The object of the invention is also achieved by a solid-state image sensing device comprising: a semiconductor substrate; a photoelectric conversion layer; a first epitaxial layer laminated on the semiconductor substrate; and a second epitaxial layer formed by epitaxial growth on the first epitaxial layer, wherein at least a part of the photoelectric conversion layer is formed in the first epitaxial layer; and the remaining part of the photoelectric conversion layer is formed in the second epitaxial layer so as to be connected to the part of the photoelectric conversion layer.

A plurality of epitaxial layers such as a third epitaxial layer, a fourth epitaxial layer, etc. may be formed. In this case, the object is achieved by a solid-state image sensing device comprising: a semiconductor substrate; a plurality of epitaxial layers laminated by epitaxial growth on the semiconductor substrate; and a photoelectric conversion layer formed so as to be continuous in a direction of lamination of the plurality of epitaxial layers.

According to the invention, the photoelectric conversion layer is formed in both the first epitaxial layer and the second epitaxial layer laminated on the first epitaxial layer. When the remaining part of the photoelectric conversion layer is formed in the second epitaxial layer after a part of the photoelectric conversion layer is formed in the first epitaxial layer, the photoelectric conversion layer having a sufficient depth in the laminating direction can be formed without necessity of using any high acceleration voltage for injecting ions into a single layer to form such a photoelectric conversion layer. As long as each of the thicknesses of the first epitaxial layer and the second epitaxial layer is set at a value allowed to be used by an ordinary acceleration voltage for ion injection, it is not necessary to increase the film thickness of each photoresist.

Moreover, once deep formation of the photoelectric conversion layer can be avoided when the photoelectric conversion layer is formed. Accordingly, a light absorption region of the photoelectric conversion layer can be prevented from being spread in the planar direction of the substrate, so that reduction in size can be prevented from being hindered.

### Brief Description of the Drawings

Fig. 1 is a view showing a procedure for laminating a first epitaxial layer on a semiconductor substrate;
Fig. 2 is a view showing a procedure for forming a p-well layer and a photodiode in the first epitaxial layer;
Fig. 3 is a view showing a procedure for forming a second epitaxial layer on the first epitaxial layer by a production method according to a first embodiment;
Fig. 4 is a view showing a procedure for forming a p-well layer in the second epitaxial layer;
Fig. 5 is a view showing a procedure for forming an overflow drain region and a transfer electrode in the second epitaxial layer;
Fig. 6 is a view showing a procedure for forming a photodiode in the second epitaxial layer;
Fig. 7 is a view showing the configuration of the first embodiment of a solid-state image sensing device according to the invention;
Fig. 8 is a view showing a procedure for forming a second epitaxial layer on a first epitaxial layer by a method according to a second embodiment;
Fig. 9 is a view showing a procedure for forming an n-type doped region in the second epitaxial layer;
Fig. 10 is a view showing a procedure for forming a first epitaxial layer on a semiconductor substrate by a method according to a third embodiment;
Fig. 11 is a view showing a procedure for forming a photodiode in the first epitaxial layer;
Fig. 12 is a view showing a procedure for forming a second epitaxial layer on the first epitaxial layer;
Fig. 13 is a view showing a procedure for forming a transfer electrode in the second epitaxial layer;
Fig. 14 is a view showing a procedure for forming a photodiode in the second epitaxial layer;
Fig. 15 is a view showing the configuration of a solid-state image sensing device according to the invention;
Fig. 16 is a view showing the configuration of the third embodiment of the solid-state image sensing device according to the invention; and
Fig. 17 is a view showing the configuration of a solid-state image sensing device according to the related art.

### Detailed Description of the Invention

Embodiments of the invention will be described below in detail with reference to the drawings.

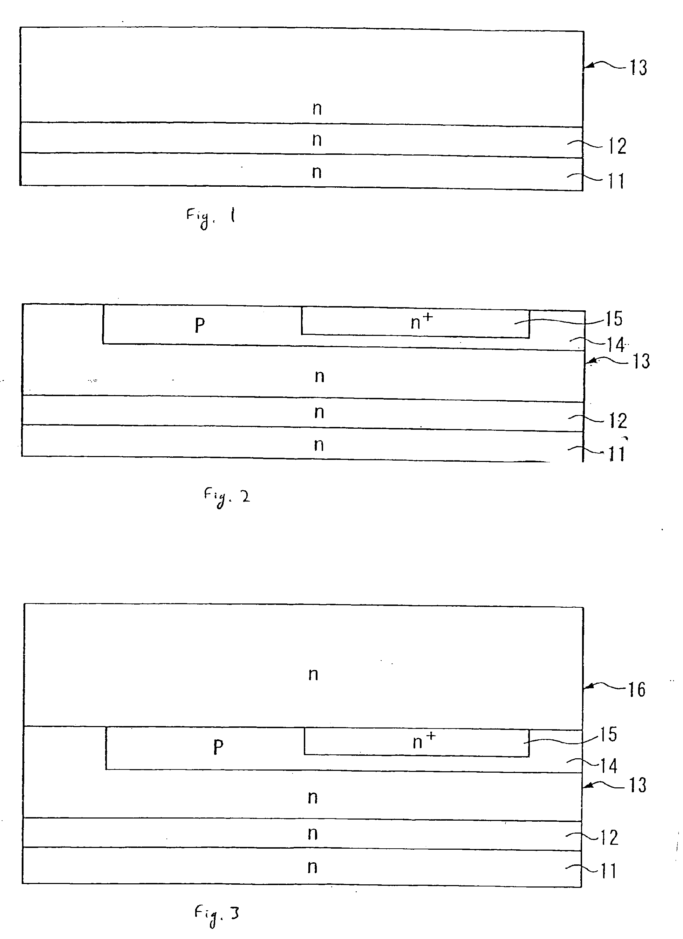

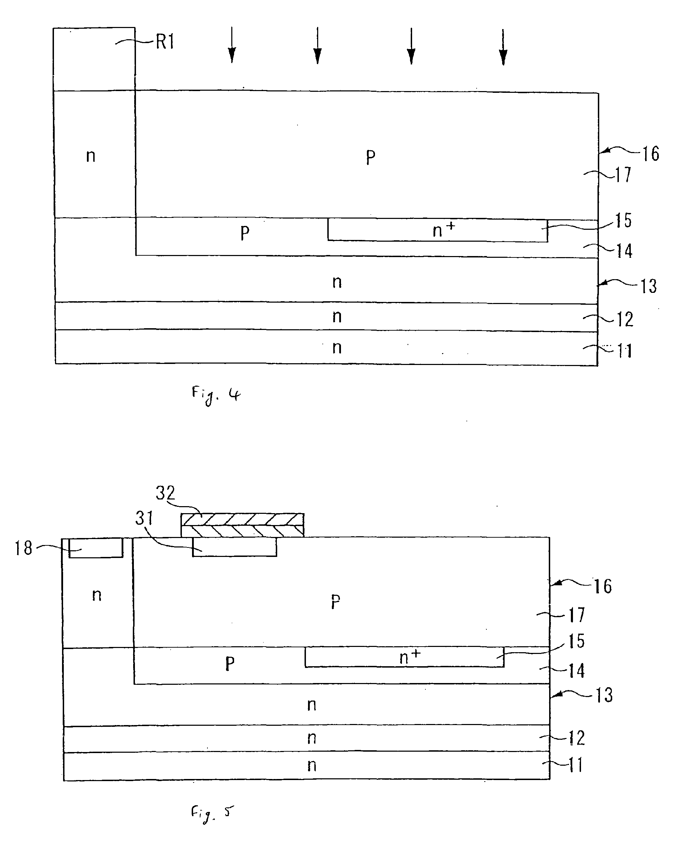

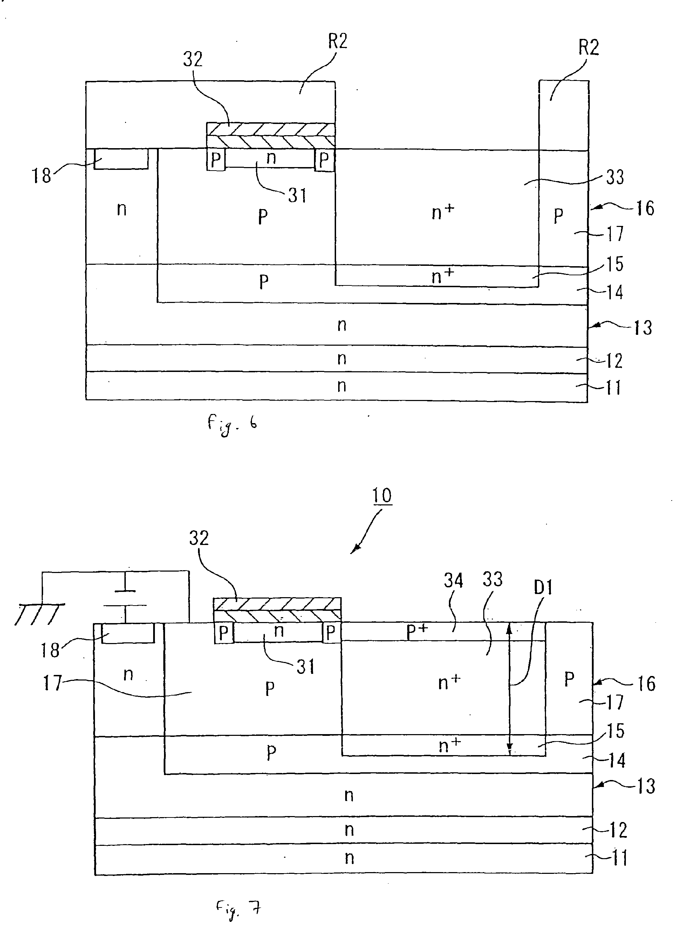

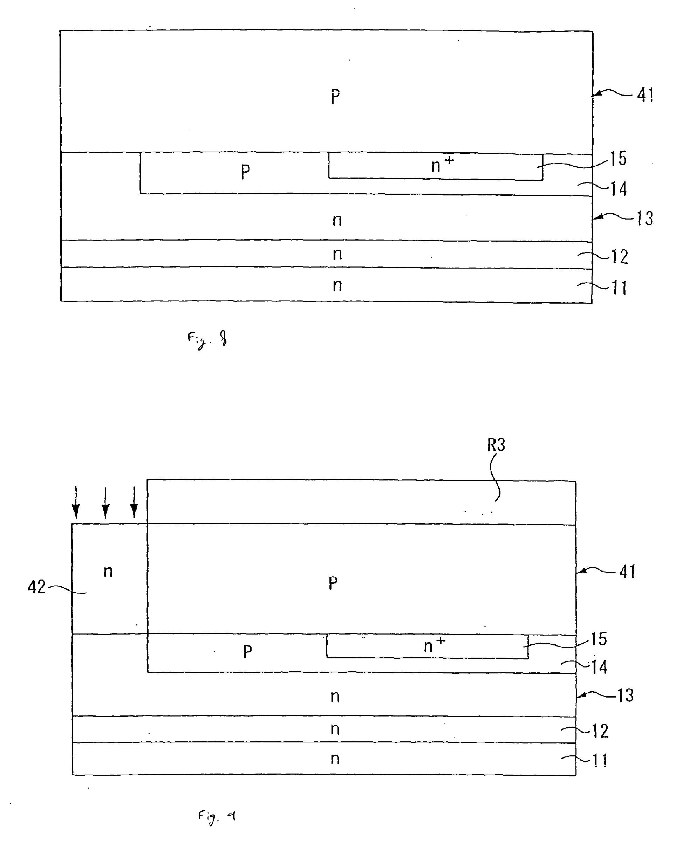

First, a first embodiment of a solid-state image sensing device producing method according to the invention will be described with reference to Figs. 1 to 7.

For example, a semiconductor substrate 11 is an n-type silicon substrate. As shown in Fig. 1, a high impurity density epitaxial layer 12 and a low impurity density epitaxial layer 13 of the same conduction type are laminated successively on the semiconductor substrate 11. In this embodiment, the low impurity density epitaxial layer 13 serves as a first epitaxial layer.

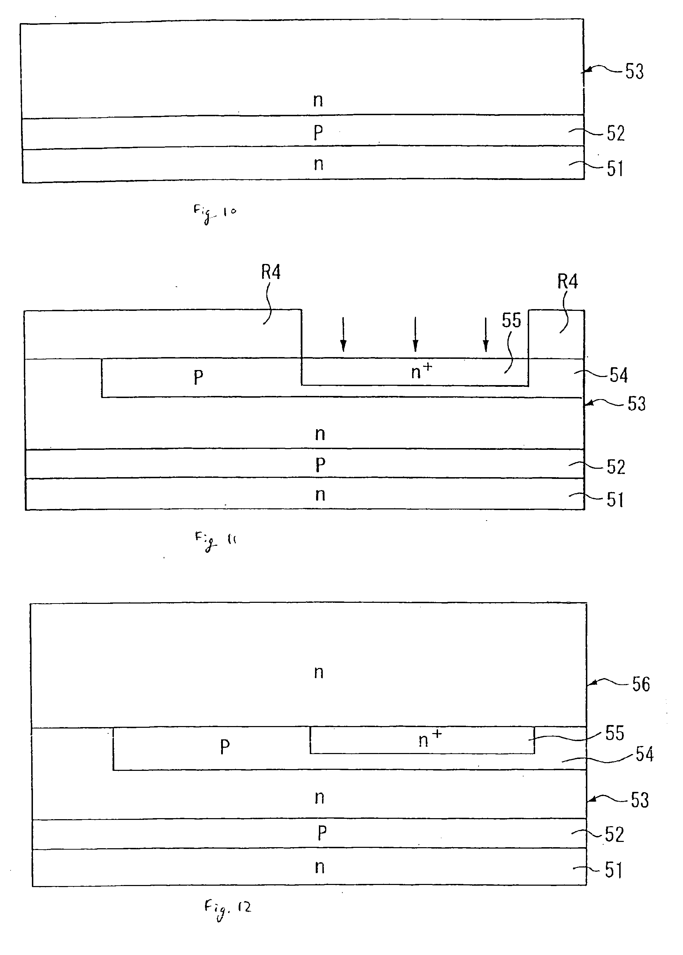

As shown in Fig. 2, after an overflow drain region of the low impurity density epitaxial layer 13 is masked with a photoresist not shown, a p-well layer 14 is formed by ion injection. High impurity density conduction type (n+ in this embodiment) ions are injected into a region corresponding to a pixel region in the p-well layer 14 to thereby form a photodiode 15 which serves as a photoelectric conversion layer.

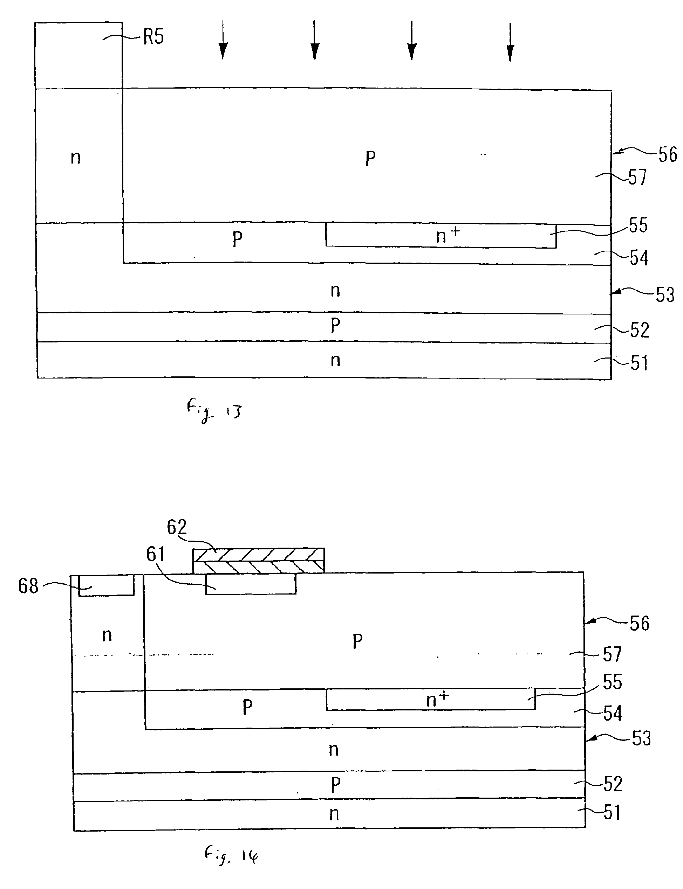

As shown in Fig. 3, a second epitaxial layer 16 is then formed on the low impurity density epitaxial layer 13 by epitaxial growth of crystal of the same conduction type (i.e. n-type) as that of the epitaxial layer 13.

As shown in Fig. 4, after the second epitaxial layer 16 is formed, a p-well layer 17 is formed by p-type impurity ion injection in the condition that a photoresist R1 serving as a mask is formed on a region (overflow drain region) of the second epitaxial layer 16 except a region of the first epitaxial layer 13 corresponding to the p-well layer 14.

As shown in Fig. 5, a vertical overflow drain region 18 is formed by injection of p-type impurity ions into the second epitaxial layer 16. After a photoresist (not shown) serving as a mask is formed with a predetermined pattern on the p-well layer 17, a charge transfer region 31 is formed by injection of n-type impurity ions. A transfer electrode 32 is formed on the charge transfer region 31 by etching or the like. A channel stop region and a charge readout region are formed on opposite sides of the charge transfer region 31 by injection of p-type impurity ions.

As shown in Fig. 6, a photodiode 33 is then formed by injection of high density impurity n+ ions after a photoresist R2 serving as a mask is formed on the transfer electrode 32 and a portion except a region where the photodiode 33 will be formed. On this occasion, the photodiode 33 is formed so that the photodiode 33 comes into contact with the photodiode 15 formed in the first epitaxial layer 13, that is, the photodiode 33 is connected to the photodiode 15 at the bottom of the second epitaxial layer 16.

As shown in Fig. 7, high density impurity ions of a condition type opposite to that of the photodiode 33 formed in the second epitaxial layer 16, i.e. p+ type ions are injected into an upper portion of the photodiode 33 to thereby form a positive charge storage region 34. Thus, a solid-state image sensing device 10 is produced. In the solid-state image sensing device 10, a photoelectric conversion layer composed of the photodiodes 15 and 33 is provided so that a part of the photoelectric conversion layer exists in the first epitaxial layer 13 while the remaining part of the photoelectric conversion layer exists in the second epitaxial layer 16. The photodiodes 15 and 33 are laid on each other by the lamination method for the epitaxial layers 13 and 16, so that the depth D1 of the photoelectric conversion layer is substantially extended. On this occasion, the depth D1 of the photoelectric conversion layer can be selected to be in a range of from 2 µm to 3 µm.

In the solid-state image sensing device producing method according to this embodiment, the photoelectric conversion layer (composed of the photodiodes 15 and 33) is formed in both the first epitaxial layer 13 and the second epitaxial layer 16 laminated on the first epitaxial layer 13. Because the remaining part (photodiode 33) of the photoelectric conversion layer is formed in the second epitaxial layer 16 after a part (photodiode 15) of the photoelectric conversion layer is formed in the first epitaxial layer 13, the photoelectric conversion layer having a sufficient depth in the laminating direction can be formed without necessity of using any high acceleration voltage for injecting ions into a single layer to form such a photoelectric conversion layer. As long as each of the thicknesses of the first epitaxial layer 13 and the second epitaxial layer 16 is set at a value allowed to be used by an ordinary acceleration voltage for ion injection, it is not necessary to increase the film thickness of each photoresist.

Moreover, once deep formation of the photoelectric conversion layer can be avoided when the photoelectric conversion layer is formed. Accordingly, the photoelectric conversion layer can be prevented from being spread in the planar direction of the substrate, so that reduction in size of an image region in the solid-state image sensing device 10 can be prevented from being hindered.

Although the solid-state image sensing device 10 according to this embodiment and the method for production thereof are configured so that the first epitaxial layer 13 and the second epitaxial layer 16 are laminated as two layers on the semiconductor substrate 11, configuration may be made so that three or more layers are laminated. That is, the solid-state image sensing device according to the invention and the method for production thereof may be configured so that a plurality of epitaxial layers (e.g. a third epitaxial layer, a fourth epitaxial layer, etc.) are laminated, and that a photoelectric conversion layer is formed so that parts of a photoelectric conversion layer are connected to one another in the direction of lamination of the plurality of epitaxial layers.

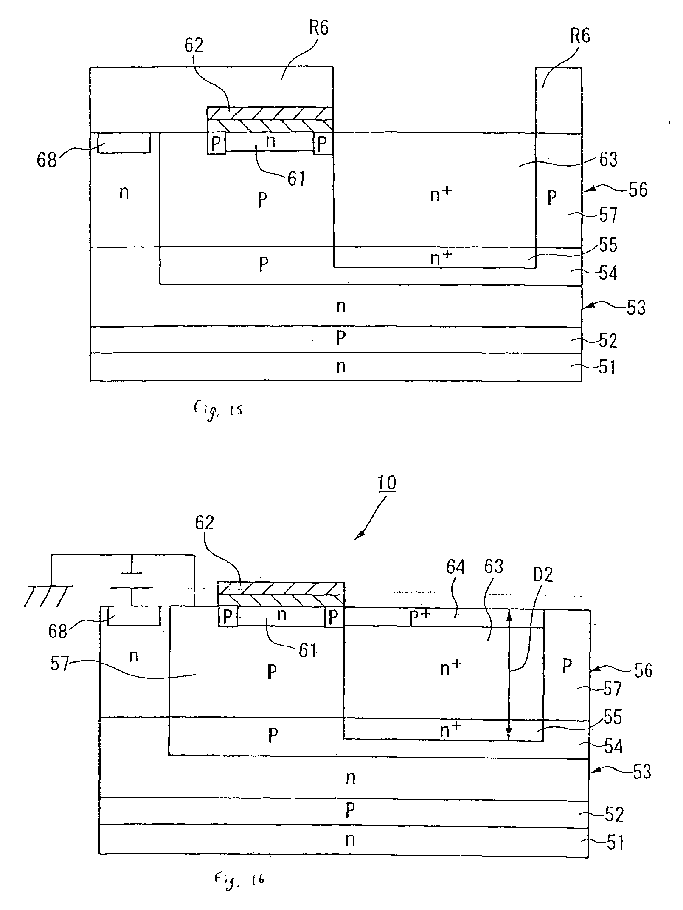

Next, a second embodiment of a solid-state image sensing device producing method according to the invention will be described with reference to Figs. 8 and 9. Incidentally, in the following embodiment, members, etc. identical in configuration and operation to the aforementioned members, etc. are referred to by the same or equivalent numerals in the drawings for the sake of simplification or omission of description thereof.

First, a high density impurity (n-type) epitaxial layer 12 and a low density impurity (n-type) epitaxial layer 13 serving as a first epitaxial layer are laminated successively on an n-type semiconductor substrate 11 in the same manner as in the first embodiment and in the same procedure as that of Figs. 1 and 2. A p-well layer 14 is formed likewise in an upper portion of the first epitaxial layer 13. A photodiode 15 is formed by injection of high density impurity n+ ions into the p-well layer 14.

In this embodiment, p-type crystal of a conduction type opposite to that of the first epitaxial layer 13 is then grown on the first epitaxial layer 13 to thereby form a p-type epitaxial layer 41 which serves as a second epitaxial layer.

In this embodiment in which the second epitaxial layer 41 of a conduction type different from that of the first epitaxial layer 13 is formed on the first epitaxial layer 13, as shown in Fig. 9, an n-type doped region 42 is formed by injection of n-type impurity ions of the same conduction type as that of the first epitaxial layer 13 into the overflow drain region in the condition that a photoresist R3 patterned to mask a predetermined region is applied on the second epitaxial layer 41. After the photoresist R3 is removed, the same procedure as shown in Figs. 5 and 6 in the aforementioned embodiment can be applied to obtain a solid-state image sensing device 10 in which a photodiode is formed in both the first epitaxial layer 13 and the second epitaxial layer 41.

In the solid-state image sensing device producing method according to this embodiment, the photoelectric conversion layer is formed continuously in the two layers 13 and 41 regardless of whether the conduction types of the first epitaxial layer 13 and the second epitaxial layer 41 are the same or not. Accordingly, it is possible to form the photoelectric conversion layer with a sufficient depth in the laminating direction in the same manner as in the first embodiment. In addition, reduction in size of an image region in the solid-state image sensing device 10 can be prevented from being hindered.

Next, a third embodiment of a solid-state image sensing device producing method according to the invention will be described with reference to Figs. 10 to 15.

In this embodiment, as shown in Fig. 10, a flat p-type layer 52 is formed on a semiconductor substrate 51 which is an n-type silicon substrate. An n-type epitaxial layer 53 serving as a first epitaxial layer is laminated on the p-type layer 52. Alternatively, the p-type layer 52 may be formed by injection of ions after the n-type epitaxial layer 53 is formed on the semiconductor substrate 51.

As shown in Figs. 11 and 12, a p-well layer 54 is formed by injection of ions into an upper portion of the first epitaxial layer 53. While the other region than a region used for forming a photoelectric conversion layer is masked with a photoresist R4 patterned to a predetermined shape, high density impurity n+ ions are injected into the p-well layer 54 to thereby form a photodiode 55.

Then, n-type impurities of the same conduction type as that of the first epitaxial layer 53 are epitaxially grown on the first epitaxial layer 53 to thereby form a second epitaxial layer 56.

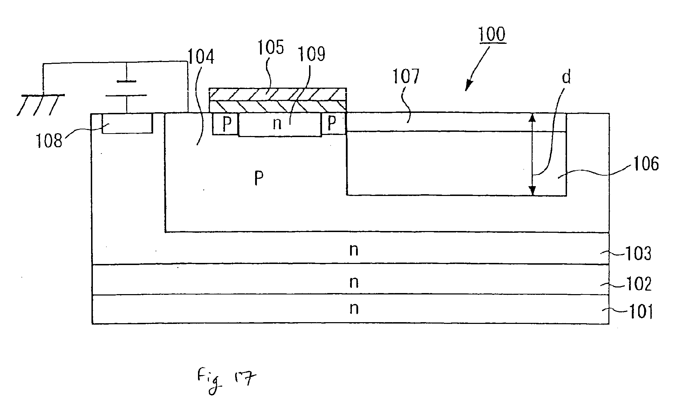

After the second epitaxial layer 56 is formed, as shown in Fig. 13, a p-well layer 57 is formed by injection of p-type impurity ions in the condition that a photoresist R5 serving as a mask is formed on a region (overflow drain region) of the second epitaxial layer 56 except a region corresponding to the p-well layer 54 of the first epitaxial layer 53.

As shown in Figs. 14 and 15, a vertical overflow drain region 68 is formed by injection of p-type impurity ions into the second epitaxial layer 56. After a photoresist (not shown) serving as a mask is formed with a predetermined pattern on the p-well layer 57, a charge transfer region 61 is also formed by injection of n-type impurity ions. A transfer electrode 62 is formed on the charge transfer region 61 by etching or the like. A channel stop region and a charge readout region are formed on opposite sides of the charge transfer region 61 by injection of p-type impurity ions.

After a photoresist R6 serving as a mask is then formed on the transfer electrode 62, a photodiode 63 is formed by injection of high density impurity n+ ions. On this occasion, the photodiode 63 is formed so that the photodiode 63 comes into contact with the photodiode 55 formed in the first epitaxial layer 53, that is, the photodiode 63 is connected to the photodiode 55 at the bottom of the second epitaxial layer 56.

As shown in Fig. 16, high density impurity ions of a conduction type opposite to that of the photodiode 63 formed in the second epitaxial layer 56, i.e. p+ type ions, are injected into an upper portion of the photodiode 63 to thereby form a positive charge storage region 64. Thus, a solid-state image sensing device 10 is produced. In the solid-state image sensing device 10, a photoelectric conversion layer composed of the photodiodes 55 and 63 is provided so that a part of the photoelectric conversion layer exists in the first epitaxial layer 53 while the remaining part of the photoelectric conversion layer exists in the second epitaxial layer 56. The photodiodes 55 and 63 are laid on each other by the lamination method of the epitaxial layers 53 and 56, so that the depth D1 of the photoelectric conversion layer is substantially extended. On this occasion, the depth D1 of the photoelectric conversion layer can be selected to be in a range of from 2 µm to 3 µm.

According to this embodiment, after a part (photodiode 55) of the photoelectric conversion layer is formed in the first epitaxial layer 53, the remaining part (photodiode 63) of the photoelectric conversion layer is formed in the second epitaxial layer 56. Accordingly, a photoelectric conversion layer having a sufficient depth in the laminating direction can be formed without necessity of using any high acceleration voltage for injecting ions into a single layer to form such a photoelectric conversion layer. As long as each of the thicknesses of the first epitaxial layer 53 and the second epitaxial layer 56 is set at a value enough to inject ions with an ordinary acceleration voltage, it is not necessary to increase the film thickness of each photoresist.

Moreover, once deep formation of the photoelectric conversion layer can be avoided when the photoelectric conversion layer is formed. Accordingly, a light absorption region of the photoelectric conversion layer can be prevented from being spread in the planar direction of the substrate, so that reduction in size of an image region in the solid-state image sensing device 10 can be prevented from being hindered.

Although this embodiment has been described on the case where the second epitaxial layer 56 is formed by epitaxial growth with the same conduction type as that of the first eptixial layer 53, an n+ type photodiode may be formed by injection of ions after a second epitaxial layer is formed by epitaxial growth with a conduction type (i.e. p-type) different from that of the first epitaxial layer 53 in the same manner as in the second embodiment.

According to the invention, it is possible to provide a solid-state image sensing device producing method and a solid-state image sensing device provided with a photodiode which can be formed deeply.

The entire disclosure of each and every foreign patent application from which the benefit of foreign priority has been claimed in the present application is incorporated herein by reference, as if fully set forth.

## Claims

1. A method of producing a solid-state image sensing device comprising a photoelectric conversion layer, the method comprising:
laminating a first epitaxial layer on a semiconductor substrate;
forming a part of the photoelectric conversion layer in the first epitaxial layer;
forming a second epitaxial layer by epitaxial growth on the first epitaxial layer; and
forming the remaining part of the photoelectric conversion layer in the second epitaxial layer to connect the remaining part of the photoelectric conversion layer to the part of the photoelectric conversion layer in the first epitaxial layer.

2. A method of producing a solid-state image sensing device comprising a photoelectric conversion layer, the method comprising:
laminating a plurality of epitaxial layers on a semiconductor substrate; and
forming the photoelectric conversion layer in the plurality of epitaxial layers so as to be continuous in a direction of lamination of the plurality of epitaxial layers.

3. A solid-state image sensing device comprising:
a semiconductor substrate;
a photoelectric conversion layer;
a first epitaxial layer laminated on the semiconductor substrate; and
a second epitaxial layer formed by epitaxial growth on the first epitaxial layer,
wherein at least a part of the photoelectric conversion layer is formed in the first epitaxial layer; and
the remaining part of the photoelectric conversion layer is formed in the second epitaxial layer so as to be connected to the part of the photoelectric conversion layer.

4. A solid-state image sensing device comprising:
a semiconductor substrate;
a plurality of epitaxial layers laminated by epitaxial growth on the semiconductor substrate; and
a photoelectric conversion layer formed so as to be continuous in a direction of lamination of the plurality of epitaxial layers.
